# EUROPÄISCHE PATENTSCHRIFT

(11) **EP 0 881 719 B1**
(45) Veröffentlichungstag und Bekanntmachung des Hinweises auf die Patenterteilung: **06.02.2002**
(21) Anmeldenummer: 98105463.8
(22) Anmeldetag: 26.03.1998
(51) Int. Cl.: H01R 12/24, H01L 23/498, H05K 1/00

(54) **Elektrische Verbindung eines beweglich angeordneten elektrischen Bauteils mit einem flexiblen elastischen Leiterbahnträger**
Electrical connection between a movable electrical component and a flexible, elastic strip conductor carrier
Connexion électrique d'un component électrique et un substrat flexible, élastique pour pistes conductives

(30) Priorität: 27.05.1997 DE 19722006
(43) Veröffentlichungstag der Anmeldung: 02.12.1998
(73) Patentinhaber: ROBERT BOSCH GMBH, 70442 Stuttgart (DE); FREUDENBERG, Carl, D-69469 Weinheim/Bergstrasse (DE)
(72) Erfinder: Gartner, Bernhard, 70597 Stuttgart (DE); Schnell, Matthias, 73650 Winterbach (DE); Wolke, Joerg, 70197 Stuttgart (DE); Schaefer, Peter, 64297 Darmstadt-Eberstadt (DE); Steinmann, Hans-Erich, 64668 Rimbach (DE); Trogisch, Günter, 64342, Seeheim-Jugenheim (DE)

(56) Entgegenhaltungen:
- EP-A- 0 375 271
- DE-A- 4 038 394
- US-A- 4 756 940
- US-A- 4 871 315

## Beschreibung

### Stand der Technik

Die Erfindung geht von einer elektrischen Verbindung gemäß der Gattung des Patentanspruchs 1 aus. Bei einer solchen, durch die DE Patentanmeldung 19 63 76 26 bekannten elektrischen Verbindung wurden Maßnahmen vorgesehen, den Leiterbahnträger in seiner Verbindung zu dem beweglichen Teil dadurch vor Stößen zu schützen, daß der Leiterbahnträger in vorgegebenen Bereichen eine Schleifenausbildung senkrecht zur Ebene des Leiterbahnträgers aufweist. Ferner wurde der Leiterbahnträger bei seiner Umlenkung ins Innere des beweglichen Bauteils an einem Gehäuserand des Bauteils fixiert, so daß im Bereich der örtlichen Fixierung innerhalb dieses Bauteils der Leiterbahnträger keinen Bewegungen mehr ausgesetzt ist. Dennoch ist weiterhin der Leiterbahnträger ab seiner Einspannstelle am Gehäuse des beweglichen Bauteils wiederum schwingenden Belastungen ausgesetzt, die für den Leiterbahnträger, je näher er an der festen Einspannstelle liegt, um so kritischer im Bezug auf einen evtl. Bruch des Leiterbahnträgers werden.

### Vorteile der Erfindung

Die erfindungsgemäße Anordnung der elektrischen Verbindung mit den kennzeichnenden Merkmalen des Patentanspruchs 1 hat demgegenüber den Vorteil, daß ein zusätzlicher Deckel an dem beweglichen Bauteil überflüssig ist und daß der Leiterbahnträger im Bereich seiner Einbettung in das bewegliche Bauteil wesentlich stabilisiert ist, welche Stabilisierung in der Folge an Stellen mit zunehmender Entfernung von der Einbettung reduziert wird, um schließlich wieder zur ursprünglich elastischen Beweglichkeit überzugehen. Damit kann dieser Leiterbahnträger auch in einer Schleife mit einem Richtungswechsel von z.B. 180° verlegt werden unter Einhaltung des maximal möglichen Umlenkradiuses.

Vorteilhafter Weiterbildung nach Patentanspruch 2 ist die Verstärkung des Leiterbahnträgers gemäß Patentanspruch 1 mehrschichtig aufgebaut. Es wird in besonders vorteilhafterweise gemäß Patentanspruch 3 die Stärke der mehrschichtigen Verstärkung mit zunehmendem Abstand von der Einbettung im elektrischen Bauteil verringert. Darüberhin kann weiterhin vorteilhaft ein Biegeradius des Leiterbahnträges unmittelbar anschließend an seine Einbettung im elektrischen Bauteil dadurch begrenzt werden, daß ein Anschlag, vorzugsweise in Form eines Teils des elektrischen Bauteils vorgesehen ist, der dem Biegeweg des elastischen Leiterbahnträgers begrenzt. Dabei kann gemäß Patentanspruch 5 bei der Einbettung den Tatsachen des tatsächlichen späteren Verlaufes des Leiterbahnträgers Rechnung getragen werden, in dem dieser in einer Vorzugslage eingebettet wird.

### Beschreibung eines Ausführungsbeispiels

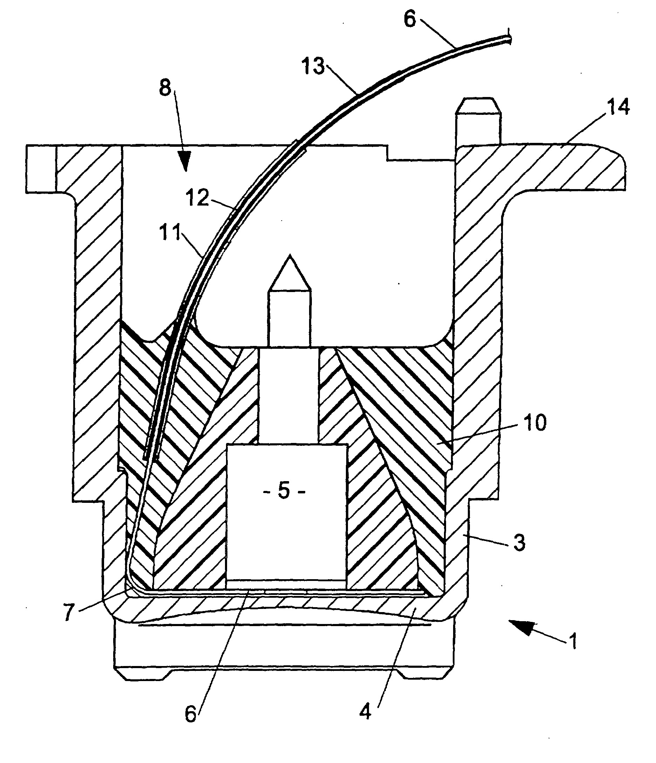

In der Figur ist ein Schnitt durch einen Drehwinkelsensor 1 wiedergegeben, wie er z.B. bei einer Verteilereinspritzpumpe zur Versorgung von selbstgezündeten Brennkraftmaschinen Verwendung findet. Dieser Drehwinkelsensor wird im Betrieb ständig entsprechend einer Spritzbeginnverstellung hin und her bewegt. Die von ihm erfassten Signale werden über einen Leiterbahnträger an eine signalverarbeitende Einrichtung weitergeleitet, wobei diese z.B. in der Art, wie sie in der EP-B1-05 13 263 wiedergegeben ist aus dem Innern des kraftstoffgefüllten Gehäuses der Verteilereinspritzpumpe nach außen geleitet wird. Die Verbindung des Leiterbahnträgers mit dem elektrischen Bauteil, dem Drehwinkelsensor 1, ist in der Figur gezeigt. Der Drehwinkelsensor weist dabei ein topfförmiges Gehäuse 3 auf, an dessen Boden 4 das Sensorelement 5 angeordnet ist. Mit diesem ist im Bereich des Bodens ein Leiterbahnträger 6, der Leiterbahnen zur Weiterleitung von Sensorsignalen aufweist, kontaktiert. Dieser Leiterbahnträger ist flexibel und derart elastisch ausgebildet, daß er auch in engen Radien umgelenkt werden kann, wie das in der Figur anhand der Umlenkstelle 7 gezeigt ist. Als Material wird dabei Kapton verwendet, das sehr gute elastische Eigenschaften aufweist. Ausgehend vom Boden 4 wird der Leiterbahnträger zur Öffnung 8 des Sensorgehäuses hin quer zur Normalen des Sensorgehäuses umgelenkt und dann im Bogen nach außen geführt. Dabei ist nur ein Teilverlauf dieses Leiterbahnträgers gezeigt. Das Innere des topfförmigen Gehäuses 3 ist durch eine Vergußmasse 10 versiegelt, die zugleich auch der Fixierung des Leiterbahnträgers innerhalb des Gehäuses 3 dient. Dabei ist dieses Gehäuse etwa zur Hälfte mit Vergußmasse ausgefüllt. Innerhalb der Einbettung in dieser Vergußmasse 10 ist der Leiterbahnträger 6 verstärkt. Dazu werden weitere Schichten des elastischen Trägermaterials auf den Leiterbahnträger aufgebracht, z.B. aufgeklebt. In vorgesehenem Falle sind es drei Schichten 11, 12 und 13, die übereinander liegend innerhalb der Einbettung der Vergußmasse 10 den Leiterbahnträger verstärken. Dabei sind die Schichten so geartet, daß die äußerste Schicht 11 bereits kurz vor oder nach Verlassen des freien nicht ausgefüllten Hohlraumes des Gehäuses 3 endet, die zweite Schicht 12 danach im Verlauf der Weiterführung des Leiterbahnträgers und anschließend dann die Schicht 13. Damit ergibt sich eine wesentliche Stabilisierung des Leiterbahnträgers beginnend in der Vergußmasse 10 und im anschließenden Verlauf des Leiterbahnträgers in speziell diesem Bereich, in dem er nach dem Austritt aus der Vergußmasse auch noch umgelenkt wird. Dabei erhält er zunächst am Austritt aus seiner Einspannstelle in der Vergußmasse eine hohe Stabilität mit etwas reduzierter Biegsamkeit. Im weiteren Verlauf, in dem nicht mehr solch hohe Biegemomente auf den Leiterbahnträger wirken, wird dann die Verstärkung abgebaut. In der Folge kann der Leiterbahnträger dann auch in einer großzügigen Schleife wieder um 180° zurück zum Austritt aus dem Gehäuse der Kraftstoffeinspritzpumpe geführt werden, so daß bei einer Querbewegung des Drehwinkelsensors 1 der Leiterbahnträger in dieser Umlenkung eine Abrollbewegung erfährt. Der Biegeradius des Leiterbahnträgers an seinem Austritt aus dem Sensorgehäuse 3 hinaus bleibt ansonsten im wesentlichen gleich.

Man erhält so eine wesentliche Stabilisierung und Sicherung gegen Versagen des Leiterbahnträgers. Dieser kann in seinem sonstigen Verlauf auch sehr dünn ausgeführt werden, was wiederum seine Verlegbarkeit und die Durchführung durch eine Gehäusedichtung nach außen fördert.

Zur weiteren Stabilisierung können Extrembiegungen des Leiterbahnträgers durch den Rand 14 des Sensorgehäuses oder durch einen anderen Anschlag begrenzt werden. Damit ergibt sich an dieser Stelle ein neuer Biegpunkt, der die Einspannstelle in der Vergußmasse 10 entlastet. Vorzugsweise wird der Leiterbahnträger bereits in einer zur Achse des Sensorgehäuses schräg verlaufenden Richtung aus der Vergußmasse 10 herausgeführt in einer Vorzugsrichtung zur Richtung der Weiterführung des Leiterbahnträgers. In diesem Bereich liegt dann auch der Anschlag 14.

## Patentansprüche

1. Elektrische Verbindung eines beweglich angeordneten elektrischen Bauteils (1) mit einem flexiblen, elastischen Leiterbahnträger(6), der aus einer elastischen, tragenden Isolierfolie besteht, auf der Leiterbahnen angeordnet sind mit denen eine elektrische Verbindung zwischen dem Bauteil (1) und einem anderen Bauteil hergestellt wird, wobei das beweglich angeordnete Bauteil topfförmig ausgebildet ist mit einer Öffnung (8), aus der heraus der Leiterbahnträger(6) so abführt, daß der Leiterbahnträger quer zur Normalen der Austrittsöffnung (8) des beweglichen Bauteils (1) abgebogen wird und in einer schleifenartigen Biegung über eine feste Einspannstelle zum anderen Bauteil geführt wird, **dadurch gekennzeichnet, daß** der Leiterbahnträger aus dem Innern des beweglichen Bauteils (1) durch eine die Innenfläche der Öffnung abdeckende Vergußmasse (10) geführt ist, in die er dicht eingebettet ist und über einen Bereich beginnend in der Einbettung bis in einen ersten Biegebereich hinein durch wenigstens eine zusätzliche elastische, tragende Isolierfolie (11, 12, 13) verstärkt ist.

2. Elektrische Verbindung nach Anspruch 1, **dadurch gekennzeichnet, daß** die Verstärkung aus mehreren übereinanderliegenden Folien besteht.

3. Elektrische Verbindung nach Anspruch 2, **dadurch gekennzeichnet, daß** alle aufgebrachten, der Verstärkung dienenden Folien(11, 12, 13) in dem Bereich der Isolierstoffeinbettung (10) beginnen und danach Folie für Folie im Laufe der Weiterführung der Leiterbahnträger (6) nacheinander enden, so daß nach einem solchermaßen gestuften Abbau der Verstärkungen schließlich nur noch der unverstärkte Leiterbahnträger (6) verbleibt, der zu der Einspannstelle und dem anderen Bauteil weiterführt.

4. Elektrische Verbindung nach einem der vorstehenden Ansprüche, **dadurch gekennzeichnet, daß** das bewegliche Bauteil (1) so ausgebildet ist, das es einen die Öffnung (8) umschließenden Topfrand (14) bildet, der eine extreme Verbiegung des Leiterbahnträger begrenzt.

5. Elektrische Verbindung nach Anspruch 1, **dadurch gekennzeichnet, daß** der Leiterbahnträger in einer Vorzugslage eingebettet ist, die exzentrisch zur Achse des beweglichen Bauteils (1) bzw. seiner Öffnung (8) liegt und dabei mit einer Anfangsneigung zur Achse des elektrischen Bauteils (1) aus der Umbettung (10) herausgeführt wird.

## Claims

1. Electrical connection of a moveably arranged electrical component (1) to a flexible, elastic conductor-track carrier (6), which comprises an elastic, carrying insulating sheet on which conductor tracks are arranged, by means of which an electrical connection is produced between the component (1) and another component, the moveably arranged component being of pot-shaped design with an opening (8), from which the conductor-track carrier (6) leads away such that the conductor-track carrier is bent away transversely with respect to the normal to the exit opening (8) of the moveable component (1) and is led in a loop-like bend via a fixed clamping point to the other component, **characterized in that** the conductor-track carrier is led from the interior of the moveable component (1) through a potting compound (10) covering the inner area of the opening, in which potting compound the said conductor-track carrier is tightly embedded and is reinforced over a region beginning in the embedding right into a first bending region by at least one additional elastic, carrying insulating sheet (11, 12, 13).

2. Electrical connection according to Claim 1, **characterized in that** the reinforcement comprises a plurality of sheets lying one above the other.

3. Electrical connection according to Claim 2, **characterized in that** all the applied sheets (11, 12, 13) serving for reinforcement begin in the region of the insulating-material embedding (10) and then end successively sheet by sheet in the course of the continuation of the conductor-track carriers (6), so that, after such stepped reduction of the reinforcements, there finally remains only the unreinforced conductor-track carrier (6), which continues to the clamping point and the other component.

4. Electrical connection according to one of the preceding claims, **characterized in that** the moveable component (1) is designed in such a way that it forms a pot edge (14) which encloses the opening (8) and limits extreme flexure of the conductor-track carrier.

5. Electrical connection according to Claim 1, **characterized in that** the conductor-track carrier is embedded in a preferred position which lies eccentrically with respect to the axis of the moveable component (1) or its opening (8) and, at the same time, is led from the embedding (10) with an initial inclination with respect to the axis of the electrical component (1).

## Revendications

1. Connexion électrique d'un composant électrique (1) mobile, et d'un substrat flexible, élastique (6) composé d'une feuille isolante et élastique portant des pistes conductrices qui assurent une liaison électrique entre le composant (1) et un autre composant, le composant mobile ayant la forme d'un pot à travers l'ouverture (8) duquel le substrat (6) sort en étant recourbé transversalement à la normale de cette ouverture (8) du composant mobile (1) pour être amené, en décrivant une boucle de flexion au-dessus d'une zone d'incorporation, à l'autre composant,
**caractérisée en ce que**
le substrat porteur des pistes conductrices, partant de l'intérieur du composant mobile (1), chemine à travers une masse de coulée (10) recouvrant la surface interne de l'ouverture et dans laquelle il est noyé, pour, à l'intérieur d'une zone commençant dans la masse et allant jusqu'à une première zone de flexion, être renforcé par au moins une feuille porteuse isolante (11, 12, 13), supplémentaire et flexible.

2. Connexion selon la revendication 1,
**caractérisée en ce que**
le renforcement est composé de plusieurs feuilles superposées.

3. Connexion selon la revendication 2,
**caractérisée en ce que**
toutes les feuilles déposées (11, 12, 13) servant au renforcement, commencent dans la zone où le substrat est noyé dans la masse coulée isolante (10) pour ensuite, au fil du cheminement du substrat (6) se terminer feuille après feuille, de sorte qu'avec une telle disparition graduée des renforcements, seul subsiste finalement le substrat (6) non renforcé, qui se poursuit jusqu'à la zone d'écartement et jusqu'à l'autre composant.

4. Connexion selon l'une quelconque des revendications précédentes,
**caractérisée en ce que**
le composant mobile (1) est configuré de manière à présenter un bord de pot (14) entourant l'ouverture (8) et constituant une limite de flexion pour le substrat.

5. Connexion selon la revendication 1,
**caractérisée en ce que**
le substrat est noyé selon une position préférentielle, excentrée par rapport à l'axe du composant mobile (1), c'est-à-dire de son ouverture (8) et à partir de laquelle, pour sortir de la masse (10) dans laquelle il est noyé, il chemine au début selon une direction oblique par rapport à l'axe du composant électrique (1).
